# EUROPEAN PATENT SPECIFICATION

(11) **EP 3 631 538 B1**
(45) Date of publication and mention of the grant of the patent: **18.01.2023**
(21) Application number: 18810137.2
(22) Date of filing: 22.05.2018
(51) Int. Cl.: G02B 5/18, G03F 7/00, G02B 27/44, B29D 11/00, G02B 27/00, G02B 27/01, B21D 37/20

(54) **METHOD OF MANUFACTURING A MASTER PLATE**
VERFAHREN ZUR HERSTELLUNG EINER MASTERPLATTE
PROCÉDÉ DE FABRICATION D'UNE PLAQUE MAÎTRESSE

(30) Priority: 02.06.2017 FI 20175505
(43) Date of publication of application: 08.04.2020
(73) Proprietor: Dispelix Oy, 02130 Espoo (FI)
(72) Inventor: RAHOM KI, Jussi, 02130 Espoo (FI); ERDMANIS, Mikhail, 02130 Espoo (FI); VARTIAINEN, Ismo, 02130 Espoo (FI)
(74) Representative: Laine IP Oy
(86) International application number: PCT/FI2018/050384
(87) International publication number: WO 2018/220272

(56) References cited:
- EP-A1- 1 930 776
- JP-A- 2006 017 788
- JP-A- 2007 057 622
- US-A1- 2004 020 892
- US-A1- 2006 151 435
- US-A1- 2008 078 741

## Description

### Field of the Invention

The invention relates to manufacturing of micro- and nanostructures for optical purposes. In particular, the invention relates to manufacturing a master plate for producing optically diffractive gratings, which can be used for example in display applications, such as near-to-eye displays.

### Background of the Invention

Near-to-eye displays (NEDs) and head-up displays (HUDs) typically involve diffractive gratings to produce a viewable image. Gratings are needed as in-coupling gratings, which couple an image from an image source to a wave guide, as out-coupling gratings, which produce the final viewable image for the user, and as exit pupil expanders (EPEs), which increase the size of the displays exit pupil.

The quality and characteristics of the gratings determine the quality of resulting image. In addition to having distinct and consistent grating lines, in advanced applications it is desirable to be able to control the diffraction efficiency of the grating locally. This can be achieved by varying grating line height or fill factor within the grating, i.e. using height or fill factor modulation. To achieve the largest possible efficiency adjustment range, both height and fill factor should be modulated. Thus, there is a need for robust and cost-effective fabrication methods for diffractive gratings in which diffraction efficiency can be freely controlled, and which are applicable for mass production.

Direct lithography and etch processes are very difficult to tune to provide high accuracy in vertical dimension, especially when features of the grating, i.e. ridges and grooves, contain several aspect ratios and depths over a large surface area. It is also difficult to achieve perfectly vertical sidewalls of features using these methods in combination with height modulation. Stamping techniques, on the other hand, require a high-quality master plate and a stamp manufactured using the master plate, whereby the main challenge is in the manufacturing of the master.

US2004020892 discloses serially masking and etching layers of a multilayer structure in order to form a multi-step optical structure. JP2006017788 discloses forming a step-like groove or ridge on a substrate. US2008078741 discloses forming a resist pattern on a substrate by patterning a resist layer using a photomask. EP1930776 discloses producing a 3D mold including irradiating a resist layer on a substrate with an electron beam and developing by thermal desorption treatment the resist layer including protrusions and depressions. US2006151435 discloses a surface processing method. JP2007057622 discloses an optical element of a phase modulation type.

Fabrication of height-modulated structures is generally done by repeating fabrication cycles in which one height is defined within one cycle. This requires several exposures with high precision alignment, see for example C. David, "Fabrication of stair-case profiles with high aspect ratios for blazed diffractive optical elements", Microelectronic Engineering, 53 (2000*).* Because of the complexity of the method, the yield is low. Moreover, overlay exposure requires a lateral placement accuracy in nanometer level, and any deviations from optimal causes losses in optical performance.

In summary, providing high-quality height modulation and fill factor modulation, and in particular their combination, in industry scale mass production of diffractive gratings is currently challenge and there is a need for improved tools and methods for this purpose.

### Summary of the Invention

It is an aim of the invention to solve at least some of the abovementioned problems and to provide a solution that help to produce high-quality optical diffractive gratings. A specific aim is to provide a method solution suitable for mass production.

The invention is based on the idea of producing, for use in a stamping technique, a master plate whose height modulation is very accurately controlled by the properties of the substrate the plate is produced on. There is provided a substrate having a selectively etchable layer structure and a mask layer using which the etching process is aided such that a desired surface profile, i.e., height modulation pattern, is achieved. The final grating structure of the master plate is produced onto the surface profile of the substrate such that its height modulation characteristics are based on the surface profile.

Thus, the invention provides a method of manufacturing a master plate for fabrication of diffractive structures, the method comprising
- providing a substrate comprising a stack of selective etch layers,
- providing an etch mask layer on the substrate,
- etching the substrate in a multi-step etching process by exposing the substrate piecewise at different mask zones of the mask layer and using said mask zones and said selective etch layers to produce to the substrate a height-modulated surface profile in accordance with the mask zones and the selective etch layers, and
- providing a height-modulated master grating onto the surface profile, the height modulation of the master grating being at last partly defined by said surface profile of the substrate.

In particular, as a result of the multi-step etching process, the surface profile of the substrate adopts lateral characteristics of the mask zones and height characteristics of the selective etch layers. That is, the surface profile is defined in lateral dimensions by the lateral arrangement of the plurality of mask zones, whereas in the height dimension the height levels are determined by the stack, i.e. the thickness properties of the selective etch layers.

The invention also provides a master plate for fabrication of diffractive structures. The plate comprises a substrate and a master grating manufactured on the substrate. The substrate comprises a stack of selectively etchable layers and has been provided with a surface profile whose height characteristics are determined by the thicknesses of the etchable layer pairs. In addition, the height characteristics of the master grating are at least partly defined by the surface profile of the substrate.

The invention is characterized by what is stated in the independent claims.

The invention offers significant benefits.

First, modulation height control is very accurate using the present method as the heights are determined by the layered substrate, which can be manufactured with nanometer-scale accuracy. Precision of 10 nm and even below is achievable over large surface areas using etchable stacks available on the market or produced as part of the process by deposition. This is an important aspect in controlling diffraction efficiency, for instance.

The present method is also very robust. Fabrication of the mask layer onto the substrate or exposing the substrate stepwise by removing the mask layer mask zones thereof does not require exceptionally high height accuracy. On the other hand, laterally the mask zones of the mask layer and the resulting imprint master typically have dimensions larger, usually by at least two orders of magnitude, than the modulation height range, whereby high lateral accuracy is not required.

The present method is fully compatible with fill factor modulation. Fill factor of the resulting master grating is determined in the very last step when the master grating is manufactured on the surface-profiled substrate. For this purpose, there are e.g. lithographic fabrication methods available that together with the high-precision substrate provide a very high-quality modulated plate.

In summary, the invention can successfully simultaneously combine grating fill factor and structure height modulation for diffraction efficiency control and suits for imprint master fabrication and therefore for mass production of gratings by a stamping or molding techniques. In particular, the method is suitable to enable diffraction grating modulation in vertical direction without extremely high requirements for lateral placement accuracy, since the grating structure is only fabricated after fully establishing the height modulation.

The dependent claims are directed to selected embodiments of the invention.

In some embodiments, the etch mask layer comprises a plurality of mask zones having different thicknesses measured from the surface of the substrate. In this case, the mask layer only determines the sequence in which zones of the substrate are exposed for etching. The lowest height is exhausted first and the highest height exposed last.

In some embodiments, the multi-step etching process comprises, for each successive etch layer pair of the substrate, removing the upper etch layer by selective etching at regions of the mask layer exposing the substrate by selective etching and, after that, removing the lower etch layer by selective etching at regions where the upper etch layer is removed. The mask layer is thinned either uniformly or by local processing until the substrate is exposed at another region of the mask layer. Thinning of the mask layer can take place by etching simultaneously with removing the lower etch layer. Alternatively, these steps can be carried out as successive steps whereby etch selectivity between the mask layer and the lower etch layer of the stack is beneficial. Lithographic thinning methods are also possible, in particular repeating a lithography step for each segment of the mask layer so as to expose the substrate locally.

In some embodiments the substrate comprises a plurality of selective etch layer pairs arranged such that the layers with different selectivities alter one after another in the stack. Each pair comprises a lower modulation layer having a first thickness and an upper etch stop layer arranged onto the modulation layer and having a second thickness smaller than the first thickness, the first and second thicknesses of the layers together defining the height modulation of the surface profile. Different pairs may have the same or different layer thicknesses, depending on the desired modulation.

In some embodiments, the stack comprises at least three etch layer pairs and the etch mask layer comprises at least a corresponding number of mask zones having different heights. Thus, a three-step modulation can be produced. In some embodiments, there are at least at least five etch layer pairs.

In some embodiments, the height-modulated master grating is provided by coating the surface profile of the substrate with planar coating layer, and removing zones of the coating layer in according to a periodic pattern in order to produce the height-modulated master grating onto the substrate. The removal may involve e.g. anisotropic etching, in particular dry etching or is done as a direct lithography step into a resist.

In some embodiments, in addition to providing height modulation through surface profiling of the substrate, the method comprises fill factor modulating the master grating.

In some embodiments, the etch mask layer is provided by coating the substrate with a uniform etchable mask layer and patterning the mask zones thereon by a microfabrication method, for example by embossing or etching, such as grayscale etching. Alternatively the etch mask layer can be produced directly with the height profile by depositing the etchable material for example by printing.

In typical optical applications, in particular wearable display applications, the required area of the master plate is at least 1 cm², such as 2 - 500 cm², which is readily achievable with the present process. The period of the master grating is typically 10 µm or less, in particular 1 µm or less, such as 200 - 800 nm.

Next, embodiments of the invention and advantages thereof are described with reference to the attached drawings.

### Brief Description of the Drawings

Figs. 1A - 1G illustrate in cross-sectional side views exemplary fabrications steps according to one embodiment of the invention.
Fig. 2A shows an example how diffraction efficiency of the first transmission order of a binary 1D grating changes as a function of the grating height.
Fig. 2B shows an example how diffraction efficiency of the first transmission order of a 1D grating changes as a function of the grating fill-factor.

### Detailed Description of Embodiments

The term "lateral" herein refers to dimensions parallel to the plane of the substrate surface, i.e. directions along the surface of the substrate. "Height" and "thickness" refer to dimension transverse to the lateral dimensions. A "surface profile" refers to variation of height of the surface in one or both lateral dimensions. Both one- and two-dimensional surface profiles, and therefore diffraction efficiency modulation in one or two dimensions of the grating, can be produced using the present method.

"Mask zones" are lateral regions of the mask layer processed during the present process in order to expose the substrate piecewise. The mask zones thus determine the order in which the different regions of the substrate are subjected to etching and therefore the surface profile.

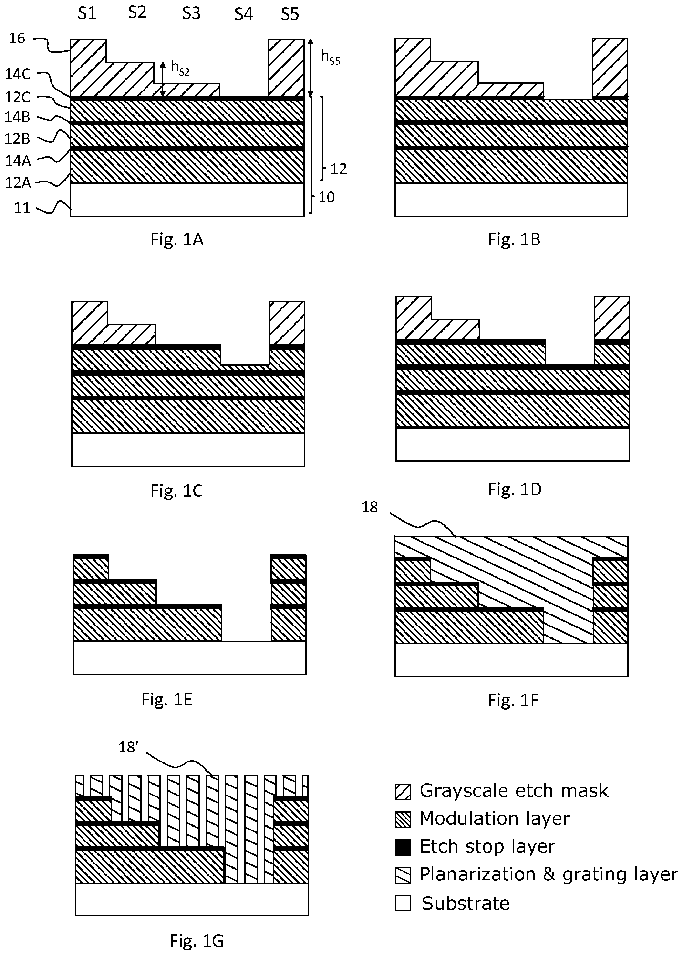

Fig. 1A shows a substrate 10 comprising a base layer 11 and a stack 12 superimposed on the base layer 11. The stack 12 comprises a plurality, in this exemplary case three, pairs of alternating etch layers 12A-C, and etch stop layers 14A-C. The layer pairs have thicknesses corresponding to the desired height modulation characteristics of the final grating. That is, the etch layers and etch stop layers together define a possible section modulation step height, as described below in more detail. The pairs can have equal or different thicknesses.

In general, the stack 12 may include layers of two or more different materials, which can be selectively etched down layer by layer. In other words, the stack 12 contains two or more different materials, which are oppositely selective for subsequent etch processes. For simplicity, a two-layer process is illustrated and described herein. A desired number of such layer pairs can be applied in the stack.

The stack 12 can be manufactured e.g. by deposition techniques, such as chemical vapor deposition (CVD), atomic layer deposition (ALD) or physical vapor deposition (PVD) using a material combination suitable for selective etching. In practice, ready-made stacks with known layer thicknesses can be used. Alternatively, the stack can be manufactured as a preparatory part of the present process.

On top of the stack 12, there is an etch mask layer 16 having a plurality, in this exemplary case five, of mask zones S1-S5. At least some of the mask zones S 1 - S5 have different heights h_{S1}-h_{S5} with respect to each other. The heights are chosen according to the requirements of the multi-step etching process as described below in more details. The widths, or if two-dimensional segmentation is desired in the height modulation pattern, lateral shapes in general, of the mask zones S1 - S5 are chosen according to the desired lateral segmentation characteristics of the end product.

The mask layer 16 may be e.g. a grayscale etch mask provided using any coating or deposition method capable of providing the required height modulation. Examples include optical lithography, electron beam lithography and imprinting, to mention some alternatives. The mask can be of relatively low in vertical, i.e. height resolution.

It should be noted that in practice the lateral dimensions of the mask zones are significantly larger than the dimensions of the vertical nodulation, although illustrated for clarity reasons in the Figures otherwise.

As illustrated in Fig. 1B, the uppermost etch stop layer 14C is opened from regions exposed by the mask layer 16 (herein at mask zone S4). If the mask layer 16 does not initially expose any region of the stack 12, it can be first uniformly etched down until the surface of the stack 12 is accessible.

Next, as shown in Fig. 1C, the underlying modulation layer 12C is etched down to the level of the next etch stop layer 14B, while simultaneously etching the mask layer 16. What is notable here is that the vertical resolution of the mask layer 16 does not need to be very accurately defined because of the etch stop layers 14A-C. This allows significant safe margins in the process to ensure that each height plane is well established. The end situation after one etch cycle is shown in Fig. 1D.

In a preferred embodiment, the next mask zone or zones (herein zone S3) of the mask layer 16 is etched completely away before reaching the bottom of the modulation layer 12C. This ensures that the etch stop layers at respective mask zones are correctly exposed for the next steps of the process to succeed.

The two-step etch cycle is repeated until all layers are etched as desired. Fig. 1E shows a situation where the etch mask layer 16 has been "consumed" and its height modulation has been transferred to the surface profile of the stack 12 as defined by its layer structure.

Next, as illustrated by Fig. 1F, a planarization layer 18 is added onto the profiled substrate such that it fills the profile. The planarization layer 18 can be for example a resist layer, spin-on glass layer or spin-on carbon layer.

Lastly, the planarization layer 18 is transformed into a height-modulated grating 18' by an appropriate lithographic methods and/or etching capable of producing a periodic structure with lateral feature dimensions the optically diffractive scale. This is depicted in Fig. 1G. In the exemplary situation, the fill factor of the grating is constant.

In some embodiments, also the fill factor of the grating is modulated at this stage. Thus, the grooves and ridged need not be of the same width throughout the grating, but may differ to further alter the diffraction efficiency.

In some embodiments, the period of the grating is modulated in addition to the height modulation and, optionally, the fill factor modulation.

Suitable lithographic methods for producing the lateral modulation include optical lithography, electron beam lithography and etching, to mention some possibilities. Also imprinting can be used, whereby the coating step of Fig. 1F can be omitted.

The described method enables improved control of high-resolution vertical features and sidewall profiles in comparison with direct grayscale lithography, where vertical sidewalls are difficult to achieve.

It should be noted that the present method is not limited to binary profiles. Thus, the profile can be slanted, mixed binary-slanted, etc. Such profiles can be achieved by e.g. using appropriate slanted grayscale etch profiles in the appropriate steps of the process.

Also the initial height modulation can be either positive or negative.

The period of the master grating is typically a fraction of minimum lateral dimensions of the mask zones. For example, the mask zones, which determine diffraction efficiency segments in the final product, can have dimensions of 0.5 mm or more, whereas the grating period is typically 10 µm or less, in particular 1 µm or less, such as 200 - 800 nm.

To give one exemplary suitable material combination of the present structure, the mask layer can consist of photoresist, the etch stop layers can consist of SiO₂ (applicable using PVD or CVD, for example), the modulation layers can consist of aluminum (applicable using PVD, for example), the planarization layer and the grating layer can consist of electron beam lithography resist and the substrate can be a silicon substrate.

The present master plate can be used to produce diffractive optical elements having laterally non-constant diffraction efficiency for various needs. In particular, the plate can be used to produce large elements, typically having an area of 1 cm² or more, for example for NEDs or HUDs. Variable diffraction efficiency provides advantages in in-coupling gratings, exit pupil expanders and/or out-coupling gratings of diffractive waveguide displays, such as smart glasses and virtual reality and augmented reality displays.

The master plate produced using the present method can be used in stamping processes, which are known *per se* in the art of producing diffractive gratings.

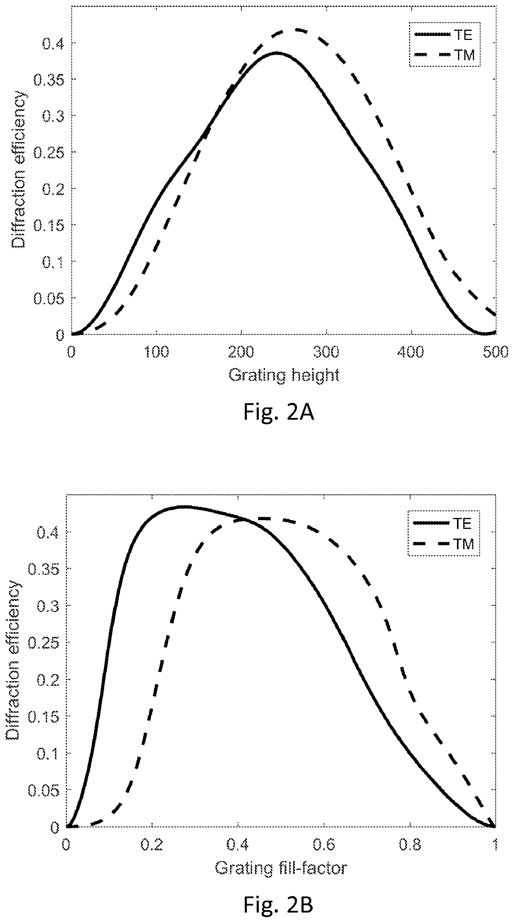

Figs. 2A and 2B show how the diffraction efficiency of the first transmission order of a dielectric binary grating can be modulated using height and fill-factor modulation. Numerical results were obtained with the Fourier modal method (also known as rigorous coupled wave analysis). The binary grating resides on an interface between air and a glass substrate having refractive index of 2.0, the grating period is 500 nm, fill factor 0.5, and the grating is made of the same material as the substrate. The grating is illuminated with a plane wave with 450 nm free space wavelength at normal incidence. Results are shown for both transverse electric (TE) and transverse magnetic polarizations (TM). In Fig. 2A, the grating fill factor is 0.5 and in Fig. 2B, the grating height is 250 nm.

### Citations list

### Non-patent literature

C. David, "Fabrication of stair-case profiles with high aspect ratios for blazed diffractive optical elements", Microelectronic Engineering, 53 (2000).

## Claims

1. A method of manufacturing a master plate for fabrication of diffractive structures, the method comprising
- providing a substrate (10) comprising a stack (12) of selective etch layers (12A-C, 14A-C) formed by a plurality of pairs of alternating etch layers (12A-C) and etch stop layers (14A-C), which are oppositely selective for subsequent etch processes,
- providing an etch mask layer (16) on the substrate (10), wherein said multi-step etching process comprises
- exposing the substrate (10) piecewise at different mask zones (S1-S5) of the mask layer (16) and using said selective etch layers (12A-C, 14A-C) to produce to the substrate (10) a height-modulated surface profile defined by the mask zones (S1-S5) in lateral dimensions and by said stack (12) in height dimension of the substrate (10), and
- providing a height-modulated master grating (18') onto the surface profile, the height modulation of the master grating (18') being at least partly defined by said surface profile of the substrate (10),
**characterized in that** said providing a height-modulated master grating (18') comprises
- coating the substrate (10) with a planar coating-layer (18) such that the surface profile is covered, and
- removing zones of the coating layer according to a periodic pattern in order to produce the height-modulated master grating (18') onto the substrate (10).

2. The method according to claim 1, wherein the etch mask layer (16) comprises a plurality of mask zones (S 1-S5) having different thicknesses measured from the surface of the substrate (10).

3. The method according to claim 2, wherein said stepwise exposing of the substrate (10) comprises thinning the mask layer (16) uniformly until the substrate (10) is exposed at least at one mask zone (S1-S5).

4. The method according to claim 1 or 2, wherein said stepwise exposing of the substrate (10) comprises locally thinning the mask layer (16) in one or more steps until the substrate (10) is exposed at least at one mask zone (S1-S5).

5. The method according to claim 4, wherein said stepwise exposing of the substrate (10) comprises repeating a lithography step for each region of the mask layer (16) until the substrate (10) is exposed at least at one mask zone (S1-S5).

6. The method according to any of the preceding claims, wherein the multi-step etching process comprises, for each successive etch layer pair (12A,14A; 12B, 14B; 12C, 14C) of the substrate (10),
- removing the upper etch layer (14A; 14B; 14C) by selective etching at regions of the mask layer (16), where the substrate (10) is exposed,
- removing the lower etch layer (12A; 12B; 12C) by selective etching at regions where the upper etch layer (14A; 14B; 14C) is removed, and
- optionally, exposing the substrate (10) at the region of another mask zone (S1-S5).

7. The method according to claims 3 and 6, wherein removing the lower etch layer (12A; 12B; 12C) and uniformly thinning the mask layer (16) occurs at least partly simultaneously in a single etching phase.

8. The method according to any of the preceding claims, wherein the stack (12) of selective etch layers (12A-C, 14A-C) comprises a stack (12) of selective etch layer pairs (12A,14A; 12B, 14B; 12C, 14C) comprising a lower modulation layer (12A; 12B; 12C) having a first thickness and an upper etch stop layer (14A; 14B; 14C) arranged onto the modulation layer (12A; 12B; 12C), the first and second thicknesses of the layers together defining the height modulation of the surface profile.

9. The method according to claim 8, wherein the second thickness is smaller than the first thickness.

10. The method according to any of the preceding claims, wherein said stack (12) comprises at least three etch layer pairs (12A,14A; 12B, 14B; 12C, 14C), such as at least five etch layer pairs, and the etch mask layer (16) at least a corresponding number of mask zones (S1-S5) having different heights.

11. The method according to any of the preceding claims, wherein said removing zones of the coating layer takes place by anisotropic etching.

12. The method according to any of the preceding claims, wherein the master grating (18') is additionally fill factor modulated.

13. The method according to any of the preceding claims, wherein the etch mask layer (16) is provided by
- coating the substrate (10) with a uniform etchable mask layer and patterning the mask zones (S1-S5) thereon by a microfabrication method, for example by embossing or etching, such as grayscale etching, or
- providing the mask zones (S1-S5) on the substrate by depositing the etchable material, for example by printing.

14. The method according to any of the preceding claims, wherein a master plate is manufactured, that has a lateral area of at least 1 cm², such as 2 - 500 cm², and wherein the period of the master grating is 10 µm or less, in particular 1 µm or less, such as 200 - 800 nm.

## Patentansprüche

1. Verfahren zur Herstellung einer Masterplatte für die Fertigung von diffraktiven Strukturen, wobei das Verfahren umfasst
- Bereitstellen eines Substrats (10), das einen Stapel (12) selektiver Ätzschichten (12A-C, 14A-C) umfasst, die durch eine Vielzahl von Paaren alternierender Ätzschichten (12A-C) und Ätzstoppschichten (14A-C) gebildet werden, die für nachfolgende Ätzprozesse entgegengesetzt selektiv sind,
- Bereitstellen einer Ätzmaskenschicht (16) auf dem Substrat (10), wobei der mehrstufige Ätzprozess umfasst
- stückweises Freilegen des Substrats (10) an verschiedenen Maskenzonen (S1-S5) der Maskenschicht (16) und Verwenden der selektiven Ätzschichten (12A-C, 14A-C), um auf dem Substrat (10) ein höhenmoduliertes Oberflächenprofil zu erzeugen, das durch die Maskenzonen (S1-S5) in lateralen Dimensionen und durch den Stapel (12) in der Höhendimension des Substrats (10) definiert ist, und
- Bereitstellen eines höhenmodulierten Mastergitters (18') auf dem Oberflächenprofil, wobei die Höhenmodulation des Mastergitters (18') zumindest teilweise durch das Oberflächenprofil des Substrats (10) definiert ist,
**dadurch gekennzeichnet, dass** das Bereitstellen eines höhenmodulierten Mastergitters (18') umfasst
- Beschichten des Substrats (10) mit einer planaren Beschichtungsschicht (18), so dass das Oberflächenprofil abgedeckt wird, und
- Entfernen von Zonen der Beschichtungsschicht gemäß einem periodischen Muster, um das höhenmodulierte Mastergitter (18') auf dem Substrat (10) zu erzeugen.

2. Verfahren nach Anspruch 1, wobei die Ätzmaskenschicht (16) eine Vielzahl von Maskenzonen (S1-S5) mit unterschiedlichen Dicken, gemessen von der Oberfläche des Substrats (10), umfasst.

3. Verfahren nach Anspruch 2, wobei das schrittweise Freilegen des Substrats (10) ein gleichmäßiges Ausdünnen der Maskenschicht (16), bis das Substrat (10) an mindestens einer Maskenzone (S1-S5) freigelegt ist, umfasst.

4. Verfahren nach Anspruch 1 oder 2, wobei das schrittweise Freilegen des Substrats (10) ein lokales Ausdünnen der Maskenschicht (16) in einem oder mehreren Schritten, bis das Substrat (10) an mindestens einer Maskenzone (S1-S5) freigelegt ist, umfasst.

5. Verfahren nach Anspruch 4, wobei das schrittweise Freilegen des Substrats (10) das Wiederholen eines Lithografieschritts für jeden für jeden Bereich der Maskenschicht (16), bis das Substrat (10) an mindestens einer Maskenzone (S1-S5) freigelegt ist, umfasst.

6. Verfahren nach einem der vorstehenden Ansprüche, wobei der mehrstufige Ätzprozess für jedes aufeinanderfolgende Ätzschichtpaar (12A, 14A; 12B, 14B; 12C, 14C) des Substrats (10) umfasst
- Entfernen der oberen Ätzschicht (14A; 14B; 14C) durch selektives Ätzen in Bereichen der Maskenschicht (16), in denen das Substrat (10) freigelegt ist,
- Entfernen der unteren Ätzschicht (12A; 12B; 12C) durch selektives Ätzen in Bereichen, in denen die obere Ätzschicht (14A; 14B; 14C) entfernt ist, und
- optional Freilegen des Substrats (10) im Bereich einer anderen Maskenzone (S1-S5).

7. Verfahren nach den Ansprüchen 3 und 6, wobei das Entfernen der unteren Ätzschicht (12A; 12B; 12C) und das gleichmäßige Ausdünnen der Maskenschicht (16) zumindest teilweise gleichzeitig in einer einzigen Ätzphase erfolgen.

8. Verfahren nach einem der vorstehenden Ansprüche, wobei der Stapel (12) selektiver Ätzschichten (12A-C, 14A-C) einen Stapel (12) selektiver Ätzschichtpaare (12A, 14A; 12B, 14B; 12C, 14C) mit einer unteren Modulationsschicht (12A; 12B; 12C) mit einer ersten Dicke und einer oberen Ätzstoppschicht (14A; 14B; 14C), die auf der Modulationsschicht (12A; 12B; 12C) angeordnet ist, umfasst, wobei die erste und zweite Dicke der Schichten zusammen die Höhenmodulation des Oberflächenprofils definieren.

9. Verfahren nach Anspruch 8, wobei die zweite Dicke geringer ist als die erste Dicke.

10. Verfahren nach einem der vorstehenden Ansprüche, wobei der Stapel (12) mindestens drei Ätzschichtpaare (12A, 14A; 12B, 14B; 12C, 14C), wie mindestens fünf Ätzschichtpaare, umfasst und die Ätzmaskenschicht (16) mindestens eine entsprechende Anzahl von Maskenzonen (S1-S5) mit unterschiedlichen Höhen aufweist.

11. Verfahren nach einem der vorstehenden Ansprüche, wobei das Entfernen von Zonen der Beschichtungsschicht durch anisotropes Ätzen erfolgt.

12. Verfahren nach einem der vorstehenden Ansprüche, wobei das Mastergitter (18') zusätzlich füllfaktormoduliert wird.

13. Verfahren nach einem der vorstehenden Ansprüche, wobei die Ätzmaskenschicht (16) bereitgestellt wird durch
- Beschichten des Substrats (10) mit einer einheitlichen ätzbaren Maskenschicht und Strukturieren der Maskenzonen (S1-S5) darauf durch ein Mikrofertigungsverfahren, beispielsweise durch Prägen oder Ätzen, wie Graustufenätzen, oder
- Bereitstellen der Maskenzonen (S1-S5) auf dem Substrat durch Aufbringen des ätzbaren Materials, beispielsweise durch Drucken.

14. Verfahren nach einem der vorstehenden Ansprüche, wobei eine Masterplatte hergestellt wird, die eine Seitenfläche von mindestens 1 cm², wie 2 - 500 cm², aufweist, und wobei die Periode des Mastergitters 10 µm oder weniger, insbesondere 1 µm oder weniger, wie 200 - 800 nm, beträgt.

## Revendications

1. Procédé d'élaboration d'un gabarit de reproduction pour la fabrication de structures diffractives, le procédé comprenant
- une fourniture d'un substrat (10) comprenant un empilement (12) de couches de gravure sélective (12A-C, 14A-C) formé par une pluralité de paires de couches de gravure (12A-C) et de couches d'arrêt de gravure (14A-C) en alternance, qui sont sélectives de manière opposée pour des processus de gravure ultérieurs,
- une fourniture d'une couche de masque de gravure (16) sur le substrat (10), dans lequel ledit processus de gravure à plusieurs étapes comprend
- une exposition du substrat (10) par morceaux au niveau de différentes zones de masque (S1-S5) de la couche de masque (16) et une utilisation desdites couches de gravure sélective (12A-C, 14A-C) pour produire sur le substrat (10) un profil de surface modulé en hauteur défini par les zones de masque (S1-S5) dans des dimensions latérales et par ledit empilement (12) dans une dimension de hauteur du substrat (10), et
- une fourniture d'un réseau de reproduction modulé en hauteur (18') sur le profil de surface, la modulation en hauteur du réseau de reproduction (18') étant au moins partiellement définie par ledit profil de surface du substrat (10),
**caractérisé en ce que** ladite fourniture d'un réseau de reproduction modulé en hauteur (18') comprend
- un revêtement du substrat (10) d'une couche de revêtement plane (18) de sorte que le profil de surface soit couvert, et
- un retrait de zones de la couche de revêtement conformément à un motif périodique afin de produire le réseau de reproduction modulé en hauteur (18') sur le substrat (10).

2. Procédé selon la revendication 1, dans lequel la couche de masque de gravure (16) comprend une pluralité de zones de masque (S1-S5) présentant différentes épaisseurs mesurées à partir de la surface du substrat (10).

3. Procédé selon la revendication 2, dans lequel ladite exposition par étapes du substrat (10) comprend un amincissement de la couche de masque (16) uniformément jusqu'à ce que le substrat (10) soit exposé au moins au niveau d'une zone de masque (S1-S5).

4. Procédé selon la revendication 1 ou 2, dans lequel ladite exposition par étapes du substrat (10) comprend un amincissement de la couche de masque (16) localement en une ou plusieurs étapes jusqu'à ce que le substrat (10) soit exposé au moins au niveau d'une zone de masque (S1-S5).

5. Procédé selon la revendication 4, dans lequel ladite exposition par étapes du substrat (10) comprend une répétition d'une étape de lithographie pour chaque région de la couche de masque (16) jusqu'à ce que le substrat (10) soit exposé au moins au niveau d'une zone de masque (S1-S5).

6. Procédé selon l'une quelconque des revendications précédentes, dans lequel le processus de gravure à plusieurs étapes comprend, pour chaque paire de couches de gravure successives (12A, 14A ; 12B, 14B ; 12C, 14C) du substrat (10),
- un retrait de la couche de gravure supérieure (14A ; 14B ; 14C) par gravure sélective au niveau de régions de la couche de masque (16), où le substrat (10) est exposé,
- un retrait de la couche de gravure inférieure (12A; 12B ; 12C) par gravure sélective au niveau de régions où la couche de gravure supérieure (14A ; 14B ; 14C) est retirée, et
- optionnellement, une exposition du substrat (10) au niveau de la région d'une autre zone de masque (S1-S5).

7. Procédé selon les revendications 3 et 6, dans lequel le retrait de la couche de gravure inférieure (12A ; 12B ; 12C) et l'amincissement de manière uniforme de la couche de masque (16) se produisent au moins partiellement simultanément dans une seule phase de gravure.

8. Procédé selon l'une quelconque des revendications précédentes, dans lequel l'empilement (12) de couches de gravure sélective (12A-C, 14A-C) comprend un empilement (12) de paires de couches de gravure sélective (12A, 14A; 12B, 14B ; 12C, 14C) comprenant une couche de modulation inférieure (12A; 12B ; 12C) présentant une première épaisseur et une couche d'arrêt de gravure supérieure (14A ; 14B ; 14C) agencée sur la couche de modulation (12A ; 12B ; 12C), les première et seconde épaisseurs des couches définissant ensemble la modulation en hauteur du profil de surface.

9. Procédé selon la revendication 8, dans lequel la seconde épaisseur est plus petite que la première épaisseur.

10. Procédé selon l'une quelconque des revendications précédentes, dans lequel ledit empilement (12) comprend au moins trois paires de couches de gravure (12A, 14A ; 12B, 14B ; 12C, 14C), telles qu'au moins cinq paires de couches de gravure, et la couche de masque de gravure (16) au moins un nombre correspondant de zones de masque (S1-S5) présentant différentes hauteurs.

11. Procédé selon l'une quelconque des revendications précédentes, dans lequel ledit retrait de zones de la couche de revêtement a lieu par gravure anisotrope.

12. Procédé selon l'une quelconque des revendications précédentes, dans lequel le réseau de reproduction (18') est de plus modulé en facteur de forme.

13. Procédé selon l'une quelconque des revendications précédentes, dans lequel la couche de masque de gravure (16) est fournie en
- revêtant le substrat (10) d'une couche de masque à graver uniforme et modelant les zones de masque (S1-S5) sur celle-ci par un procédé de microfabrication, par exemple par emboutissage ou gravure, telle que gravure achromatique, ou
- fournissant les zones de masque (S1-S5) sur le substrat en déposant le matériau à graver, par exemple par impression.

14. Procédé selon l'une quelconque des revendications précédentes, dans lequel un gabarit de reproduction est élaboré, qui présente une superficie latérale d'au moins 1 cm², telle que 2 - 500 cm², et dans lequel la période du réseau de reproduction est 10 µm ou moins, en particulier 1 µm ou moins, telle que 200 - 800 nm.
